# EUROPEAN PATENT APPLICATION

(11) **EP 4 539 629 A1**
(43) Date of publication of application: **16.04.2025**
(21) Application number: 24199777.4
(22) Date of filing: 11.09.2024
(51) Int. Cl.: H10D 30/65, H10D 30/67, H10D 62/13, H10D 62/17, H10D 30/01, H10D 30/00, H10D 62/10, B82Y 10/00

(54) **SEMICONDUCTOR DEVICE WITH INCREASED OPERATING VOLTAGE CHARACTERISTICS**

(30) Priority: 13.10.2023 US 202318486832
(71) Applicant: Avago Technologies International Sales Pte. Limited, Singapore 768923 (SG)
(72) Inventor: Ito, Akira, Irvine, 92618 (US)
(74) Representative: Dilg, Haeusler, Schindelmann Patentanwaltsgesellschaft mbH

(57) **Abstract**

A semiconductor device, such as a gate-all-around field-effect transistor (GAAFET), that can provide advantages in terms of higher operating voltages. The semiconductor device includes a substrate with a p-type well, an n-type well, and a depletion region; an insulating layer disposed on the p-type well; a first epitaxial layer disposed on the insulating layer; a second epitaxial layer disposed on the p-type well, the n-type well, and/or the depletion region; and a gate formed around a channel and between the first epitaxial layer and the second epitaxial layer.

## Description

### BACKGROUND

The present disclosure relates, in general, to semiconductor fabrication technology. More particularly, the present disclosure relates to semiconductor device structures that can be used to provide a more diverse range of operating voltages for implementations of gate-all-around field-effect transistor (GAAFET) devices and other similar devices. For example, the semiconductor device structures described herein can be used in various implementations of laterally diffused metal-oxide-semiconductors (LDMOS) for use in a variety of different high-power applications such as power amplifiers, radio frequency (RF) amplifiers, and power transistors for radio and wireless communication systems. As the demand for high-power applications increases, research and development efforts continue to advance semiconductor technologies to meet manufacturing capabilities and capacities of foundries and enhance the functionality of various electronic devices and circuits.

### BRIEF DESCRIPTION OF THE DRAWINGS

FIG. 1 shows a cross section illustrating example components of a semiconductor device, in accordance with some aspects of the disclosure.
FIG. 2 shows a top view of the example semiconductor device of FIG. 1, in accordance with some aspects of the disclosure.
FIG. 3 shows a cross section illustrating example components of another semiconductor device, in accordance with some aspects of the disclosure.
FIG. 4 shows a cross section illustrating example components of a further semiconductor device, in accordance with some aspects of the disclosure.

### DETAILED DESCRIPTION

In the following description, for the purposes of explanation, numerous details are set forth to provide a thorough understanding of the disclosure. It will be apparent to one skilled in the art, however, that other aspects can be practiced without some details. Different examples are described herein, and while various features are ascribed to the examples, it should be appreciated that the features described with respect to one example may be incorporated with other examples as well. By the same token, however, no single feature or features of any described example should be considered essential to every example, as other examples may omit such features.

When an element is referred to herein as being "connected" or "coupled" to another element, it is to be understood that the elements can be directly connected to the other element, or have intervening elements present between the elements. In contrast, when an element is referred to as being "directly connected" or "directly coupled" to another element, it should be understood that no intervening elements are present in the "direct" connection between the elements. However, the existence of a direct connection does not exclude other connections, in which intervening elements may be present.

When an element is referred to herein as being "disposed" in some manner relative to another element (e.g., disposed on, disposed between, disposed under, disposed adjacent to, or disposed in some other relative manner), it is to be understood that the elements can be directly disposed relative to the other element (e.g., disposed directly on another element), or have intervening elements present between the elements. In contrast, when an element is referred to as being "disposed directly" relative to another element, it should be understood that no intervening elements are present in the "direct" example. However, the existence of a direct disposition does not exclude other examples in which intervening elements may be present.

Likewise, when an element is referred to herein as being a "layer", it is to be understood that the layer can be a single layer or include multiple layers. For example, a conductive layer can include multiple different conductive materials or multiple layers of different conductive materials, and a dielectric layer may comprise multiple dielectric materials or multiple layers of dielectric materials. When a layer is described as being coupled or connected to another layer, it is to be understood that the coupled or connected layers may include intervening elements present between the coupled or connected layers. In contrast, when a layer is referred to as being "directly" connected or coupled to another layer, it should be understood that no intervening elements are present between the layers. However, the existence of directly coupled or connected layers does not exclude other connections in which intervening elements may be present.

Moreover, the terms left, right, front, back, top, bottom, forward, reverse, clockwise and counterclockwise are used for purposes of explanation only and are not limited to any fixed direction or orientation. Rather, they are used merely to indicate relative locations and/or directions between various parts of an object and/or components.

Furthermore, unless otherwise indicated, all numbers used herein to express quantities, dimensions, and so forth should be understood as being modified in all instances by the term "about". In this application, the use of the singular includes the plural unless specifically stated otherwise, and use of the terms "and" and "or" means "and/or" unless otherwise indicated. Moreover, the use of the terms "including" and "having", as well as other forms, such as "includes", "included", "has", "have", and "had", should be considered non-exclusive. Also, terms such as "element" or "component" encompass both elements and components comprising one unit and elements and components that comprise more than one unit, unless specifically stated otherwise.

While some features and aspects have been described with respect to the examples, one skilled in the art will recognize that numerous modifications are possible. For example, the methods and processes described herein may be implemented using hardware components, custom integrated circuits (ICs), programmable logic, and/or any combination thereof. Further, while various methods and processes described herein may be described with respect to particular structural and/or functional components for ease of description, methods provided by various embodiments are not limited to any particular structural and/or functional architecture but instead can be implemented in any suitable hardware configuration. Similarly, while some functionality is ascribed to one or more system components, unless the context dictates otherwise, this functionality can be distributed among various other system components in accordance with the several embodiments.

Moreover, while the procedures of the methods and processes described herein are described in a particular order for ease of description, unless the context dictates otherwise, various procedures may be reordered, added, and/or omitted in accordance with various implementations. Moreover, the procedures described with respect to one method or process may be incorporated within other described methods or processes; likewise, system components described according to a particular structural architecture and/or with respect to one system may be organized in alternative structural architectures and/or incorporated within other described systems. Hence, while various examples are described with or without some features for ease of description and to illustrate aspects of those embodiments, the various components and/or features described herein with respect to a particular example can be substituted, added and/or subtracted from among other described embodiments, unless the context dictates otherwise. Consequently, although several examples are described above, it will be appreciated that the disclosure is intended to cover all modifications and equivalents within the scope of the following claims.

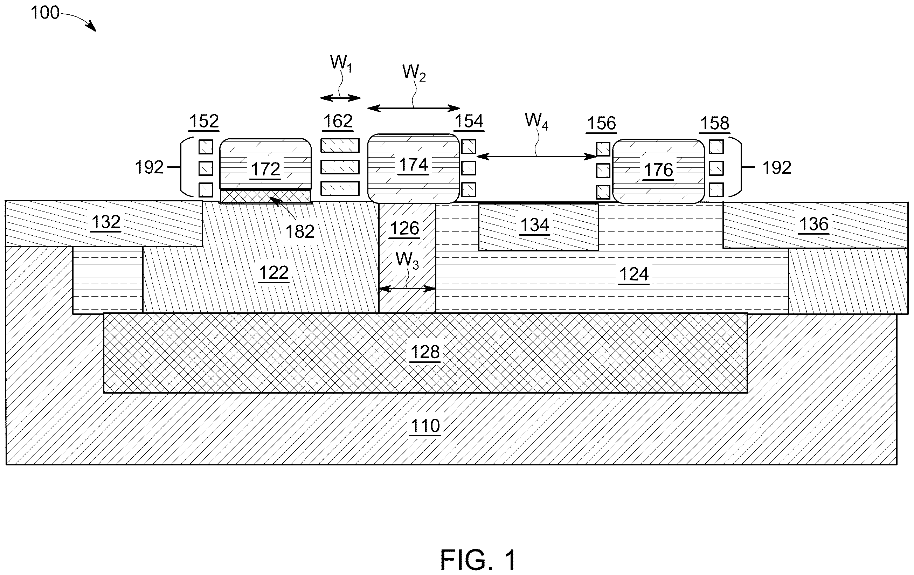

Referring to FIG. 1, a cross section illustrating example components of a semiconductor device 100 is shown, in accordance with some aspects of the disclosure. The semiconductor device 100 can be implemented as a variety of types of semiconductor devices, such as various different types and combinations of transistor structures. For example, the semiconductor device 100 may comprise a non-planar (three-dimensional) GAAFET device, such as a gate-all-around LDMOS device. As shown in FIG. 1, the semiconductor device 100 includes a plurality of channels 192 around which a gate 162 can be formed. The channels 192 can be implemented using silicon nanosheets, for example, that are anywhere from 10 nanometers to 50 nanometers wide and 5 nanometers thick, in some examples. However, the channels 192 can be implemented using any suitable type and/or construction of nanosheets, where the term nanosheets generally refers to a conductive channel structure. The channels 192 can also be implemented using silicon nanowires, among other possible implementation of the channels 192. The channels 192 can include three vertically stacked channels, in some examples, however any suitable number of channels can be used (e.g., one channel, two channels, five channels, seven channels, etc.). Various types of spacer layers can be disposed on and/or around the channels 192, such as silicon nitride and/or silicon dioxide layers.

The semiconductor device 100 as shown in FIG. 1 also includes a substrate 110, a p-type well 122, an n-type well 124, and a depletion region 126 disposed between the p-type well 122 and the n-type well 124. The substrate 110 may comprise silicon material (e.g., crystalline silicon) and/or other suitable materials or combinations of materials. The depletion region 126 can be defined by the substrate 110. The substrate 110 can be implemented using various fabrication technologies, such as using a silicon-on-insulator (SOI) structure, a bulk semiconductor structure, an alloy semiconductor, a compound semiconductor, germanium, and/or various other suitable materials and combinations thereof. The substrate 110 generally provides a base for forming components of the semiconductor device 100 thereon. It will be appreciated that the semiconductor device 100 can be implemented in a variety of different types of circuits, inducing various types of integrated circuit (IC) chips. The semiconductor device 100 is also shown to include a deep n-type well (DNW) 128 formed within the substrate 110 that can provide noise suppression within the substrate 110. The deep n-type well 128 can be formed by doping the substate 110 using any suitable n-type dopants such as arsenic, phosphorous, and/or other similar n-type dopants.

The p-type well 122 generally is a region of the substrate 110 that is doped using p-type dopants, such as boron and/or other similar p-type dopants. The n-type well 124 generally is a region of the substrate 110 that is doped using n-type dopants such as arsenic, phosphorous, and/or other similar n-type dopants. The p-type well 122 and the n-type well 124 can also be formed at least partially separate from the substrate 110, for example at least partially within various types of oxide layers and/or other insulating/dielectric layers within the semiconductor device 100. The depletion region 126 generally is an insulating region of the substrate 110, where mobile charge carriers have been diffused away and/or forced away by an electric field. The ionized donor and/or acceptor impurities left in the depletion region 126 result in a depletion of charge carriers within the depletion region 126, thereby limiting the amount of current that can flow through the depletion region 126. The depletion region 126 can be lightly doped with a p-type dopant, in some examples, to help sustain higher operating voltages.

The semiconductor device 100 as shown in FIG. 1 also includes an isolation structure 132, an isolation structure 134, and an isolation structure 136. The isolation structure 132, the isolation structure 134, and the isolation structure 136 can be shallow trench isolation (STI) structures, for example, among other possible types of isolations structures (e.g., dielectric material layers, etc.). The isolation structure 132, the isolation structure 134, and the isolation structure 136 can be formed as a result of etching trenches in the semiconductor device 100. For example, after etching a trench between the epitaxial layer 174 and the epitaxial layer 176, the isolation structure 134 can be formed by depositing a dielectric material at least partially within the trench. The isolation structure 132 and the isolation structure 136 can be formed in a similar manner. The dielectric material used to form the isolation structure 132, the isolation structure 134, and the isolation structure 136 can be, for example, silicon oxide, silicon nitride, and/or other suitable materials and combinations of materials. The isolation structure 132, the isolation structure 134, and the isolation structure 136 can prevent leakage of electric current between different components of the semiconductor device 100.

The semiconductor device 100 as shown in FIG. 1 also includes various epitaxial layers including an epitaxial layer 172, an epitaxial layer 174, and an epitaxial layer 176. Also, the semiconductor device 100 as shown in FIG. 1 includes an insulating layer 182 that is disposed on the p-type well 122. The insulating layer 182 may comprise using any suitable materials, such as silicon nitride, aluminum oxide, silicon dioxide, and/or other suitable insulating materials and combinations thereof. The epitaxial layer 172, the epitaxial layer 174, and the epitaxial layer 176 can be formed using various types of epitaxy processes and a variety of suitable epitaxial materials. For example, the epitaxial layer 172, the epitaxial layer 174, and the epitaxial layer 176 can be formed using silicon, gallium arsenide, and/or other suitable epitaxial materials and combinations thereof. In the semiconductor device 100, the epitaxial layer 172, the epitaxial layer 174, and the epitaxial layer 176 can be highly doped using suitable n-type dopants such as arsenic, phosphorous, and/or other similar n-type dopants. Notably, as shown in FIG. 1, the epitaxial layer 172 can be disposed on the insulating layer 182, whereas the epitaxial layer 174 can be disposed on the p-type well 122, the n-type well 124, and/or the depletion region 126. and the epitaxial layer 176 can be disposed on the n-type well 124. The epitaxial layer 172 can be used ultimately to form a source terminal of a transistor (e.g., after forming a silicide layer and an interconnect on the epitaxial layer 172), whereas the epitaxial layer 176 can be used ultimately to form a drain terminal of a transistor (e.g., after forming a silicide layer and an interconnect on the epitaxial layer 176).

The semiconductor device 100 as shown in FIG. 1 also includes layers of polysilicon material formed on oxide definition region edges (PODE). Specifically, the semiconductor device 100 is shown to include a PODE layer 152, a PODE layer 154, a PODE layer 156, and a PODE layer 158. The PODE layer 152, the PODE layer 154, the PODE layer 156, and the PODE layer 158 can generally be "dummy" polysilicon segments (e.g., "dummy" refers to a dummy segment that is tied to ground or supply and not intended to function actively) formed on edges of different silicone oxide definition regions (e.g., active regions) of the semiconductor device 100 to prevent degradation of the semiconductor device 100 due to transistor faceting near the edges of the oxide definition regions. As shown, the PODE layer 152 can be formed adjacent to the epitaxial layer 172 on an opposite side of the epitaxial layer 172 relative to the gate 162. The PODE layer 154 can be formed adjacent to the epitaxial layer 174 on an opposite side of the epitaxial layer 174 relative to the gate 162. The PODE layer 156 and the PODE layer 158, respectively, can be formed adjacent to the epitaxial layer 176 on opposing sides of the epitaxial layer 176.

The gate 162 can be formed around the channels 192 and between the epitaxial layer 172 and the epitaxial layer 174 such that the channels 192 are surrounded on all sides by the gate 162. The gate 162 can be formed using polysilicon material (e.g., to provide a high-k gate) and/or another suitable material or combination of materials (e.g., a metal gate). Voltage applied at the gate 162 can generally control the operation and conductance of the semiconductor device 100. Various types of spacers can be formed at least partially around the gate 162 to electrically isolate the gate 162 and prevent charge leakage. The spacers may comprise materials with high dielectric constants such as silicon nitride, silicon oxide, and/or other suitable materials and combinations thereof. Additionally, a gate oxide layer can be formed between the gate 162 and the channels 192 using materials such as silicon nitride, aluminum oxide, silicon dioxide, and/or other suitable materials and combinations thereof. A silicide layer can be formed on the gate 162 (e.g., using a trench silicidation process), and an interconnect can be landed on the gate 162 to form a gate terminal of a transistor. It will be appreciated that the gate 162 can be formed around the channels 192 in a variety of ways. For example, the gate 162 can completely surround the channels 192 or the gate 162 can partially surround the channels 192 (e.g., gaps can exist between the channels 192 and the gate 162, the gate 162 can completely surround some of the channels 192 and partially surround some of the channels 192, etc.).

The structure of the semiconductor device 100 as shown in FIG. 1 can provide various advantages in terms of providing higher operating voltages. In some previous designs of devices including GAAFET devices and other similar types of devices, the operating range may be limited to around 0.75V-0.9V. This operating voltage limitation can make use of these devices in power applications challenging. In these designs, relative to the structure of the semiconductor device 100 as shown in FIG. 1, the middle epitaxial layer (e.g., the epitaxial layer analogous to the epitaxial layer 174) is typically formed on an insulating layer similar to the insulating layer 182. That is, the middle epitaxial layer is typically disposed on an insulating layer that is disposed on a p-type well of a substrate (e.g., analogous to the p-type well 122). Moreover, the previous designs also do not include a depletion region (e.g., analogous to the depletion region 126) between n- and p-type wells. As a result of this structure, when higher operating voltages are applied, the current flowing through the device does not face enough resistance, and therefore various components of these devices can be damaged and/or the devices can become inoperable.

However, the structure of the semiconductor device 100 as shown in FIG. 1 can provide added resistance to current flowing through the semiconductor device 100 when higher operating voltages are applied, thereby making the semiconductor device 100 more suitable for power applications. For example, when using the semiconductor device 100, the operating range can be increased to around 1.8V-3.0V. By removing the isolation of the epitaxial layer 174 (e.g., by not including an insulating layer similar to the insulating layer 182), the depletion region 126 below the epitaxial layer 174 and the n-type well 124 form a drift region, which can limit current flow through the semiconductor device 100. In some examples, the depletion region 126 may be partially or fully replaced by the n-type well 124, however, as the removal of the isolation of the epitaxial layer 174 can still limit current flow within the semiconductor device 100. The epitaxial layer 174 can still serve as a "floating" layer along with the n-type well 124 that provides a drift region within the semiconductor device 100 due to the n-type doping of the epitaxial layer 174 and the positioning of the epitaxial layer 174 on the n-type well 124 without isolation. For example, if the epitaxial layer 174 is lightly doped, then the depletion region 126 may not be needed to form the drift region within the semiconductor device 100, and the epitaxial layer 174 can be formed only on the n-type well 124.

In FIG. 1, various widths of different components of the semiconductor device 100 are shown. A width W₁ of the gate 162 can be between 3 nanometers and 100 nanometers. A width W₂ of the epitaxial layer 174 can be between 40 nanometers and 100 nanometers. A width W₃ of the depletion region 126 can be between 5 nanometers and 300 nanometers, or can be 0 nanometers in implementation where the depletion region 126 is not included in the semiconductor device 100. A width W₄ of the shallow trench isolation 134 can be between 40 nanometers and 300 nanometers. As shown in FIG. 1, the shallow trench isolation 134 can be formed between the PODE layer 154 and the PODE layer 156, and thereby between the epitaxial layer 174 and the epitaxial layer 176, as well as within the n-type well 124. The specific dimensions of these components can provide advantages in terms of facilitating proper operation of the semiconductor device 100 under higher operating voltage conditions.

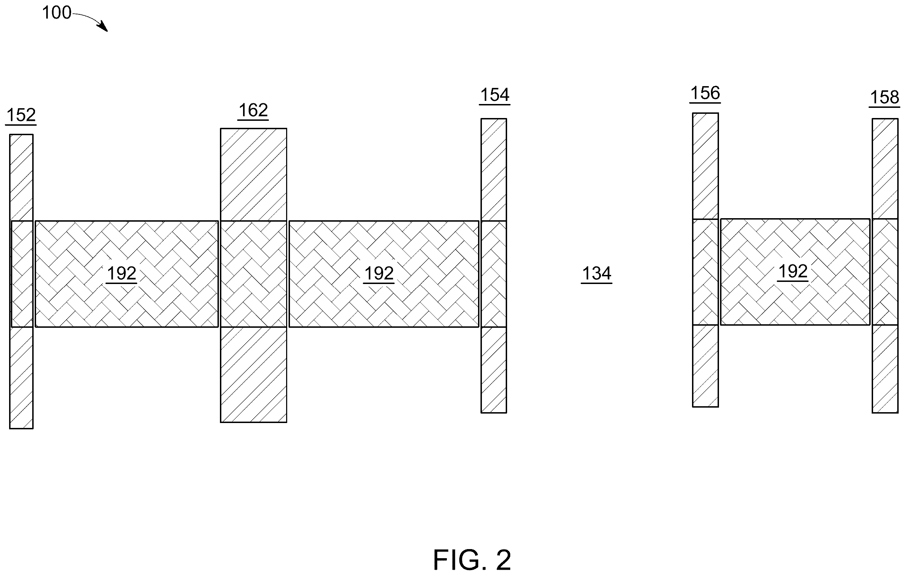

Referring to FIG. 2, a top view of the example semiconductor device 100 is shown, in accordance with some aspects of the disclosure. Specifically, from the top view shown in FIG. 2, the channels 192 can be seen relative to the gate 162 as well as the PODE layer 152, the PODE layer 154, the PODE layer 156, and the PODE layer 158. Also, the location of the shallow trench isolation 134 can be seen from the top view shown in FIG. 2. As noted, to form the shallow trench isolation 134, an associated trench can be etched through the channels 192 and into the n-type well 124. This specific location of the shallow trench isolation 134 and the dimensions of the shallow trench isolation 134 as noted above can provide advantages in terms of facilitating proper operation of the semiconductor device 100 under higher operating voltage conditions due to the electrical characteristics exhibited by the semiconductor device 100.

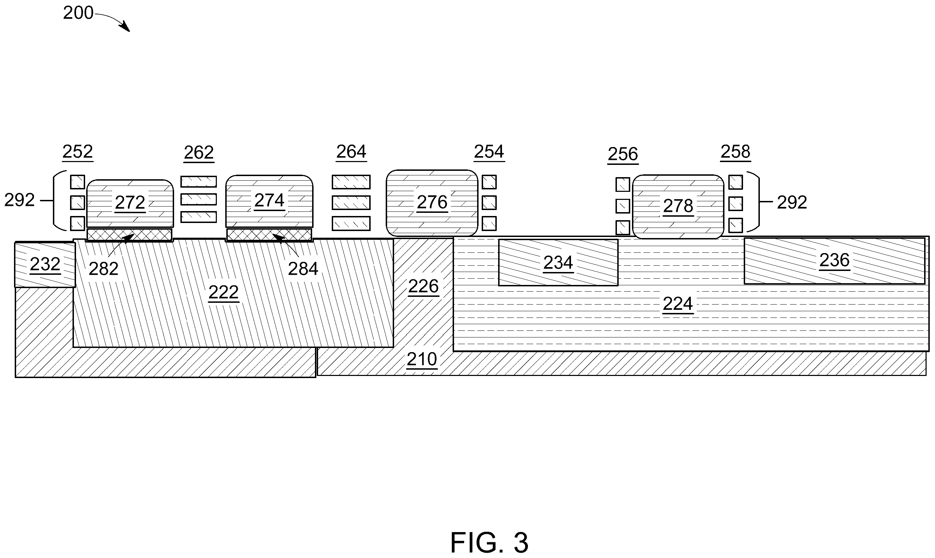

Referring to FIG. 3, a cross section illustrating example components of another example semiconductor device 200 is shown, in accordance with some aspects of the disclosure. As shown, the structure of the semiconductor device 200 is similar to the semiconductor device 100 as shown in FIG. 1, however the semiconductor device 200 provides a split gate structure that includes both a gate 262 and a gate 264. Like the semiconductor device 100, the semiconductor device 200 can be implemented as a variety of types of semiconductor devices, such as various different types and combinations of transistor structures. For example, the semiconductor device 200 can be a non-planar (three-dimensional) GAAFET device, such as a gate-all-around LDMOS device.

As shown in FIG. 3, the semiconductor device 200 includes a plurality of channels 292 around which both the gate 262 and the gate 264 can be formed. The channels 292 can be implemented using silicon nanosheets, for example, that are anywhere from 10 nanometers to 50 nanometers wide and 5 nanometers thick, in some examples. The channels 292 can also be implemented using silicon nanowires, among other possible implementation of the channels 292. The channels 292 can include three vertically stacked channels, in some examples, however any suitable number of channels can be used (e.g., one channel, two channels, five channels, seven channels, etc.). Various types of spacer layers can be disposed on and/or around the channels 292, such as silicon nitride and/or silicon dioxide layers. The channels 292 can be implemented using any suitable type and/or construction of nanosheets, where the term nanosheets generally refers to a conductive channel structure.

The semiconductor device 200 as shown in FIG. 3 also includes a substrate 210, a p-type well 222, an n-type well 224, and a depletion region 226 disposed between the p-type well 222 and the n-type well 224. The depletion region 226 can be defined by the substrate 210. The substrate 210 can be formed of silicon material (e.g., crystalline silicon) and/or other suitable materials or combinations of materials. The substrate 210 can be implemented using various fabrication technologies, such as using an SOI structure, a bulk semiconductor structure, an alloy semiconductor, a compound semiconductor, germanium, and/or various other suitable materials and combinations thereof. The substrate 210 generally provides a base for forming components of the semiconductor device 200 thereon. It will be appreciated that the semiconductor device 200 can be implemented in a variety of different types of circuits, inducing various types of IC chips.

The p-type well 222 generally is a region of the substrate 210 that is doped using p-type dopants, such as boron and/or other similar p-type dopants. The n-type well 224 generally is a region of the substrate 210 that is doped using n-type dopants such as arsenic, phosphorous, and/or other similar n-type dopants. The p-type well 222 and the n-type well 224 can also be formed at least partially separate from the substrate 210, for example at least partially within various types of oxide layers and/or other insulating/dielectric layers within the semiconductor device 200. The depletion region 226 generally is an insulating region of the substrate 210 where mobile charge carriers have been diffused away and/or forced away by an electric field. The ionized donor and/or acceptor impurities left in the depletion region 226 result in a depletion of charge carriers within the depletion region 226, thereby limiting the amount of current that can flow through the depletion region 226.

The semiconductor device 200 as shown in FIG. 3 also includes an isolation structure 232, an isolation structure 234, and an isolation structure 236. The isolation structure 232, the isolation structure 234, and the isolation structure 236 can be shallow trench isolation (STI) structures, for example, among other possible types of isolations structures (e.g., dielectric material layers, etc.). The isolation structure 232, the isolation structure 234, and the isolation structure 236 can be formed as a result of etching trenches in the semiconductor device 200. For example, after etching a trench between the epitaxial layer 276 and the epitaxial layer 278, the isolation structure 234 can be formed by depositing a dielectric material at least partially within the trench. The isolation structure 232 and the isolation structure 236 can be formed in a similar manner. The dielectric material used to form the isolation structure 232, the isolation structure 234, and the isolation structure 236 can be, for example, silicon oxide, silicon nitride, and/or other suitable materials and combinations of materials. The isolation structure 232, the isolation structure 234, and the isolation structure 236 can be used to prevent leakage of electric current between different components of the semiconductor device 200.

The semiconductor device 200 as shown in FIG. 3 also includes various epitaxial layers including an epitaxial layer 272, an epitaxial layer 274, an epitaxial layer 276, and an epitaxial layer 278. The semiconductor device 200 as shown in FIG. 3 also includes an insulating layer 282 and an insulating layer 284 that are both disposed on the p-type well 122. The insulating layer 282 and the insulating layer 284 can be formed using any suitable materials, such as silicon nitride, aluminum oxide, silicon dioxide, and/or other suitable insulating materials and combinations thereof. The epitaxial layer 272, the epitaxial layer 274, the epitaxial layer 276, and the epitaxial layer 278 can be formed using various types of epitaxy processes and a variety of suitable epitaxial materials. For example, the epitaxial layer 272, the epitaxial layer 274, the epitaxial layer 276, and the epitaxial layer 278 can be formed using silicon, gallium arsenide, and/or other suitable epitaxial materials and combinations thereof.

In the semiconductor device 200, the epitaxial layer 272, the epitaxial layer 274, the epitaxial layer 276, and the epitaxial layer 278 can be highly doped using suitable n-type dopants such as arsenic, phosphorous, and/or other similar n-type dopants. Notably, as shown in FIG. 3, the epitaxial layer 272 can be disposed on the insulating layer 282 and the epitaxial layer 274 can be disposed on the insulating layer 284. In contrast, the epitaxial layer 276 can be disposed on the p-type well 222, the n-type well 224, and/or the depletion region 226, and the epitaxial layer 278 can be disposed on the n-type well 224. By removing the isolation of the epitaxial layer 276, a drift region that limits current flow within the semiconductor device 200 can be formed, similar to the drift region of the semiconductor device 100. The epitaxial layer 272 can be used ultimately to form a source terminal of a transistor (e.g., after forming a silicide layer and an interconnect on the epitaxial layer 272), whereas the epitaxial layer 278 can be used ultimately to form a drain terminal of a transistor (e.g., after forming a silicide layer and an interconnect on the epitaxial layer 278).

The semiconductor device 200 as shown in FIG. 3 also includes layers of polysilicon material formed on oxide definition region edges (PODE). Specifically, the semiconductor device 200 is shown to include a PODE layer 252, a PODE layer 254, a PODE layer 256, and a PODE layer 258. The PODE layer 252, the PODE layer 254, the PODE layer 256, and the PODE layer 258 can generally be "dummy" polysilicon segments formed on edges of different silicone oxide definition regions (e.g., active regions) of the semiconductor device 200 to prevent degradation of the semiconductor device 200 as a result of transistor faceting near the edges of the oxide definition regions. As shown, the PODE layer 252 can be formed adjacent to the epitaxial layer 272 on an opposite side of the epitaxial layer 272 relative to the gate 262. The PODE layer 254 can be formed adjacent to the epitaxial layer 276 on an opposite side of the epitaxial layer 276 relative to the gate 264. The PODE layer 256 and the PODE layer 258, respectively, can be formed adjacent to the epitaxial layer 278 on opposing sides of the epitaxial layer 278.

The gate 262 can be formed around the channels 292 and between the epitaxial layer 272 and the epitaxial layer 274 such that the channels 292 are surrounded on all sides by the gate 262. The gate 264 can be formed around the channels 292 and between the epitaxial layer 274 and the epitaxial layer 276 such that the channels 292 are surrounded on all sides by the gate 264. The gate 262 and the gate 264 can be formed using polysilicon material and/or another suitable material or combination of materials. Voltage applied at the gate 262 and/or the gate 264 can generally control the operation and conductance of the semiconductor device 200. Various types of spacers can be formed at least partially around the gate 262 and/or the gate 264 to electrically isolate the gate 262 and/or the gate 264 to prevent charge leakage. The spacers can be formed using materials with high dielectric constants such as silicon nitride, silicon oxide, and/or other suitable materials and combinations thereof. Additionally, a gate oxide layer can be formed (e.g., using thermal oxidation) between the gate 262 and/or the gate 264 and the channels 292 using materials such as silicon nitride, aluminum oxide, silicon dioxide, and/or other suitable materials and combinations thereof. It will be appreciated that the gate 262 can be formed around the channels 292 in a variety of ways. For example, the gate 262 can completely surround the channels 292 or the gate 262 can partially surround the channels 292 (e.g., gaps can exist between the channels 292 and the gate 262, the gate 262 can completely surround some of the channels 292 and partially surround some of the channels 292, etc.). The gate 264 can likewise be formed around the channels 292 in a variety of ways.

Relative to the semiconductor device 100, the use of both the gate 262 and the gate 264 can provide advantages in some applications with respect to operating of the semiconductor device 200. The semiconductor device 200 can provide similar advantages as the semiconductor device 100, including increasing the operating range to around 1.8V-3.0V. Further, it will be appreciated that the widths and other dimensional characteristics described with respect to the semiconductor device 100 also apply to the semiconductor device 200. For example, a width of the shallow trench isolation 234 can be between 40 nanometers and 300 nanometers, and a width of the depletion region 226 can be between 5 nanometers and 300 nanometers (or 0 nanometers in implementations where the depletion region 226 is not included in the semiconductor device 200). Also, a width of the epitaxial layer 276 can be between 40 nanometers and 100 nanometers, a width of the gate 262 can be between 3 nanometers and 100 nanometers, and a width of the gate 264 can also be between 3 nanometers and 100 nanometers.

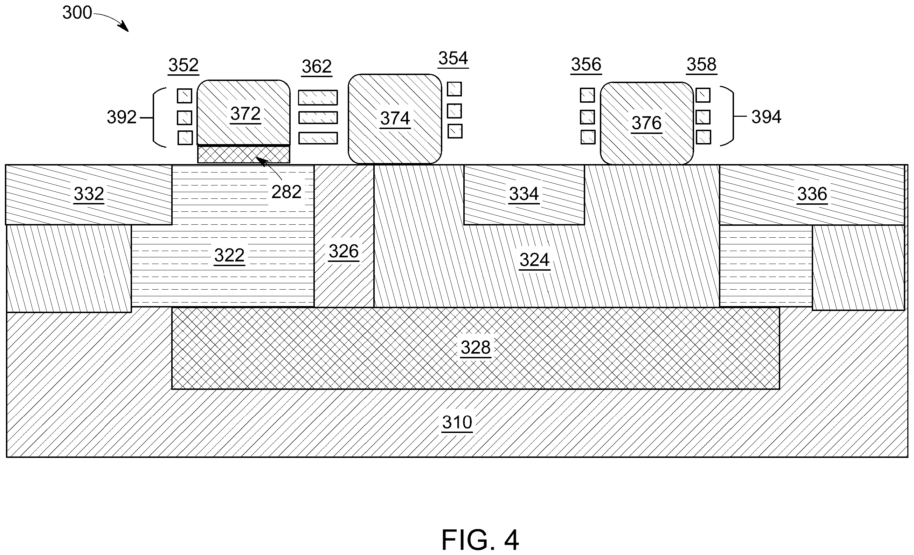

Referring to FIG. 4, a cross section illustrating example components of a further example semiconductor device 300 is shown, in accordance with some aspects of the disclosure. As shown, the structure of the semiconductor device 300 is also similar to the semiconductor device 100 as shown in FIG. 1, however the semiconductor device 300 provides a device implementation with a reversed polarity relative to the semiconductor device 100. Like the semiconductor device 100, the semiconductor device 300 can be implemented as a variety of types of semiconductor devices, such as various different types and combinations of transistor structures. For example, as detailed, the semiconductor device 300 can be a gate-all-around PLDMOS device.

As shown in FIG. 4, the semiconductor device 300 includes a plurality of channels 392 around which a gate 362 can be formed. The channels 392 can be implemented as silicon nanosheets that are anywhere from 10 nanometers to 50 nanometers wide and 5 nanometers thick, in some examples. The channels 392 can also be implemented using silicon nanowires, among other possible implementation of the channels 392. The channels 392 can include three vertically stacked channels, in some examples, however any suitable number of channels can be used (e.g., one channel, two channels, five channels, seven channels, etc.). Various types of spacer layers can be disposed on and/or around the channels 392, such as silicon nitride and/or silicon dioxide layers. The channels 392 can be implemented using any suitable type and/or construction of nanosheets, where the term nanosheets generally refers to a conductive channel structure.

The semiconductor device 300 as shown in FIG. 4 also includes a substrate 310, an n-type well 322, a p-type well 324, and a depletion region 326 that is disposed between the n-type well 322 and the p-type well 324. The depletion region 326 can be defined by the substrate 310. The substrate 310 can be formed of silicon material and/or other suitable materials and/or combinations of materials. The substrate 310 can be implemented using various fabrication technologies, such as using an SOI structure, a bulk semiconductor structure, an alloy semiconductor, a compound semiconductor, germanium, and/or various other suitable materials and combinations thereof. The substrate 310 generally provides a base for forming components of semiconductor device 300 thereon. It will be appreciated that the semiconductor device 300 can be implemented in a variety of different types of circuits, inducing various types of IC chips.

The n-type well 322 generally is a region of the substrate 310 that is doped using n-type dopants such as arsenic, phosphorous, and/or other similar n-type dopants. The p-type well 324 generally is a region of the substrate 310 that is doped using p-type dopants, such as boron and/or other similar p-type dopants. The n-type well 322 and the p-type well 324 can also be formed at least partially separate from the substrate 310, for example at least partially within various types of oxide layers and/or other insulating/dielectric layers within the semiconductor device 300. The depletion region 326 generally is an insulating region of the substrate 310 where mobile charge carriers have been diffused away and/or forced away by an electric field. The ionized donor and/or acceptor impurities left in the depletion region 326 result in a depletion of charge carriers within the depletion region 326, thereby limiting the amount of current that can flow through the depletion region 326.

The semiconductor device 300 as shown in FIG. 2 also includes an isolation structure 332, an isolation structure 334, and an isolation structure 336. The isolation structure 332, the isolation structure 334, and the isolation structure 336 can be shallow trench isolation (STI) structures, for example, among other possible types of isolations structures (e.g., dielectric material layers, etc.). The isolation structure 332, the isolation structure 334, and the isolation structure 336 can be formed as a result of etching trenches in the semiconductor device 300. For example, after etching a trench between the epitaxial layer 374 and the epitaxial layer 376, the isolation structure 334 can be formed by depositing a dielectric material at least partially within the trench. The isolation structure 332 and the isolation structure 336 can be formed in a similar manner. The dielectric material used to form the isolation structure 332, the isolation structure 334, and the isolation structure 336 can be, for example, silicon oxide, silicon nitride, and/or other suitable materials and combinations of materials. The isolation structure 332, the isolation structure 334, and the isolation structure 336 can be used to prevent leakage of electric current between different components of the semiconductor device 300.

The semiconductor device 300 as shown in FIG. 4 also includes various epitaxial layers including an epitaxial layer 372, an epitaxial layer 374, and an epitaxial layer 376. Also, the semiconductor device 300 as shown in FIG. 4 includes an insulating layer 382 that is disposed on the n-type well 322. The insulating layer 382 can be formed using any suitable materials, such as silicon nitride, aluminum oxide, silicon dioxide, and/or other suitable insulating materials and combinations thereof. The epitaxial layer 372, the epitaxial layer 374, and the epitaxial layer 376 can be formed using various types of epitaxy processes and a variety of suitable epitaxial materials. For example, the epitaxial layer 372, the epitaxial layer 374, and the epitaxial layer 376 can be formed using silicon, gallium arsenide, and/or other suitable epitaxial materials and combinations thereof.

In the semiconductor device 300, the epitaxial layer 372, the epitaxial layer 374, and the epitaxial layer 376 can be highly doped using suitable p-type dopants as boron and/or other similar p-type dopants. Notably, as shown in FIG. 4, the epitaxial layer 372 can be disposed on the insulating layer 382, whereas the epitaxial layer 374 can be disposed on the n-type well 322, the p-type well 324, and/or the depletion region 326. By removing the isolation of the epitaxial layer 374, a drift region that limits current flow within the semiconductor device 300 can be formed, similar to the drift region of the semiconductor device 100. Also, the epitaxial layer 376 can be disposed on the p-type well 324. The epitaxial layer 372 can be used ultimately to form a source terminal of a transistor (e.g., after forming a silicide layer and an interconnect on the epitaxial layer 372), whereas the epitaxial layer 376 can be used ultimately to form a drain terminal of a transistor (e.g., after forming a silicide layer and an interconnect on the epitaxial layer 376).

The semiconductor device 300 as shown in FIG. 4 also includes layers of polysilicon material formed on oxide definition region edges (PODE). Specifically, the semiconductor device 300 is shown to include a PODE layer 352, a PODE layer 354, a PODE layer 356, and a PODE layer 358. The PODE layer 352, the PODE layer 354, the PODE layer 356, and the PODE layer 358 can generally be "dummy" polysilicon segments formed on edges of different silicone oxide definition regions (e.g., active regions) of the semiconductor device 300 to prevent degradation of the semiconductor device 300 due to transistor faceting near the edges of the oxide definition regions. As shown, the PODE layer 352 can be formed adjacent to the epitaxial layer 372 on an opposite side of the epitaxial layer 372 relative to the gate 362. The PODE layer 354 can be formed adjacent to the epitaxial layer 374 on an opposite side of the epitaxial layer 374 relative to the gate 362. The PODE layer 356 and the PODE layer 358, respectively, can be formed adjacent to the epitaxial layer 376 on opposing sides of the epitaxial layer 376.

The gate 362 can be formed around the channels 392 and between the epitaxial layer 372 and the epitaxial layer 374 such that the channels 392 are surrounded on all sides by the gate 362. The gate 362 can be formed using polysilicon material and/or another suitable material or combination of materials. Voltage applied at the gate 362 can generally control the operation and conductance of the semiconductor device 300. Various types of spacers can be formed at least partially around the gate 362 to electrically isolate the gate 362 and prevent charge leakage. The spacers can be formed using materials with high dielectric constants such as silicon nitride, silicon oxide, and/or other suitable materials and combinations thereof. Additionally, a gate oxide layer can be formed between the gate 362 and the channels 392 using materials such as silicon nitride, aluminum oxide, silicon dioxide, and/or other suitable materials and combinations thereof. A silicide layer can be formed on the gate 362 (e.g., using a trench silicidation process), and an interconnect can be landed on the gate 362 to form a gate terminal of a transistor. It will be appreciated that the gate 362 can be formed around the channels 392 in a variety of ways. For example, the gate 362 can completely surround the channels 392 or the gate 362 can partially surround the channels 392 (e.g., gaps can exist between the channels 392 and the gate 362, the gate 362 can completely surround some of the channels 392 and partially surround some of the channels 392, etc.).

The semiconductor device 300 can provide similar advantages as the semiconductor device 100, including increasing the operating range to around 1.8V-3.0V. Further, it will be appreciated that the widths and other dimensional characteristics described with respect to the semiconductor device 100 also apply to the semiconductor device 300. For example, a width of the shallow trench isolation 334 can be between 40 nanometers and 300 nanometers, and a width of the depletion region 326 can be between 5 nanometers and 300 nanometers (or 0 nanometers in implementations where the depletion region 326 is not included in the semiconductor device 300). Also, a width of the epitaxial layer 374 can be between 40 nanometers and 100 nanometers and a width of the gate 362 can be between 3 nanometers and 100 nanometers.

## Claims

1. A semiconductor device, comprising:
a substrate comprising a p-type well, an n-type well, and a depletion region, the depletion region being disposed between the p-type well and the n-type well;
an insulating layer disposed on the p-type well;
a first epitaxial layer disposed on the insulating layer;
a second epitaxial layer disposed on the n-type well and on the depletion region; and
a gate formed around a channel and between the first epitaxial layer and the second epitaxial layer.

2. The semiconductor device of claim 1, wherein
the second epitaxial layer comprises an n-type dopant.

3. The semiconductor device of claim 1 or 2, comprising
a third epitaxial layer disposed on the n-type well, wherein
the second epitaxial layer is disposed between the first epitaxial layer and the third epitaxial layer.

4. The semiconductor device of claim 3, wherein
the third epitaxial layer comprises an n-type dopant.

5. The semiconductor device of claim 3 or 4, wherein:
the n-type well comprises an isolation structure disposed between the second epitaxial layer and the third epitaxial layer; and
a width of the isolation structure disposed between the second epitaxial layer and the third epitaxial layer is between 40 nanometers and 300 nanometers.

6. The semiconductor device of any one of the preceding claims, comprising at least one of the following features:
(A) a width of the depletion region is between 5 nanometers and 300 nanometers;
(B) a width of the second epitaxial layer is between 40 nanometers and 100 nanometers;
(C) a width of the gate is between 3 nanometers and 100 nanometers; and
(D) the gate comprises a polysilicon gate and the channel comprises a silicon nanosheet.

7. A semiconductor device, comprising:
a substrate comprising a p-type well, an n-type well, and a depletion region, the depletion region being disposed between the p-type well and the n-type well;
an insulating layer disposed on the n-type well;
a first epitaxial layer disposed on the insulating layer;
a second epitaxial layer disposed on the depletion region; and
a gate formed around a channel and between the first epitaxial layer and the second epitaxial layer.

8. The semiconductor device of claim 7, wherein
the second epitaxial layer comprises a p-type dopant.

9. The semiconductor device of claim 7 or 8, comprising
a third epitaxial layer, third epitaxial layer doped with a p-type dopant and disposed on the p-type well, wherein the second epitaxial layer is disposed between the first epitaxial layer and the third epitaxial layer.

10. The semiconductor device of claim 9, wherein:
the p-type well comprises an isolation structure disposed between the second epitaxial layer and the third epitaxial layer; and
a width of the isolation structure disposed between the second epitaxial layer and the third epitaxial layer is between 40 nanometers and 300 nanometers.

11. The semiconductor device of any one of the claims 7 to 10, comprising at least one of the following features:
(A) a width of the depletion region is between 5 nanometers and 300 nanometers;
(B) a width of the second epitaxial layer is between 40 nanometers and 100 nanometers;
(C) a width of the gate is between 3 nanometers and 100 nanometers; and
(D) the gate comprises a polysilicon gate and the channel comprises a silicon nanosheet.

12. A semiconductor device, comprising:
a substrate comprising a p-type well, an n-type well, and a depletion region, the depletion region being disposed between the p-type well and the n-type well;
a first insulating layer disposed on the p-type well;
a first epitaxial layer disposed on the first insulating layer;
a second insulating layer disposed on the p-type well;
a second epitaxial layer disposed on the second insulating layer;
a third epitaxial layer disposed on the depletion region;
a first gate formed around a channel and between the first epitaxial layer and the second epitaxial layer; and
a second gate formed around the channel and between the second epitaxial layer and the third epitaxial layer.

13. The semiconductor device of claim 12, wherein
the third epitaxial layer comprises an n-type dopant.

14. The semiconductor device of claim 12 or 13, comprising
a fourth epitaxial layer, the fourth epitaxial layer doped with an n-type dopant and disposed on the n-type well, wherein the third epitaxial layer is disposed between the second epitaxial layer and the fourth epitaxial layer;
wherein in particular
the n-type well comprises an isolation structure disposed between the third epitaxial layer and the fourth epitaxial layer; and
a width of the isolation structure disposed between the third epitaxial layer and the fourth epitaxial layer is between 40 nanometers and 300 nanometers.

15. The semiconductor device of any one of the claims 12 to 14, comprising at least one of the following features:
(A) a width of the depletion region is between 5 nanometers and 300 nanometers;
(B) a width of the third epitaxial layer is between 40 nanometers and 100 nanometers;
(C) a width of the first gate is between 3 nanometers and 100 nanometers; and
(D) a width of the second gate is between 3 nanometers and 100 nanometers.
